(19) Europäisches Patentamt / European Patent Office / Office européen des brevets

(11) **EP 2 309 638 A1**

(12) **EUROPEAN PATENT APPLICATION**

(43) Date of publication:
**13.04.2011 Bulletin 2011/15**

(51) Int Cl.:
*H02M 7/483* (2007.01)    *H03F 3/217* (2006.01)
*H02M 1/12* (2006.01)

(21) Application number: **09252395.0**

(22) Date of filing: **09.10.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(71) Applicant: **NXP B.V.**
**5656 AG Eindhoven (NL)**

(72) Inventors:
• **Bergveld, Hendrik Johannes**
  **Redhill, Surrey RH1 1DL (GB)**
• **Garcia I Tormo, Albert**
  **Redhill, Surrey RH1 1DL (GB)**

• **Alarcón, Eduard**
  **Redhill, Surrey RH1 1DL (GB)**
• **Poveda, Alberto**
  **Redhill, Surrey RH1 1DL (GB)**
• **Buter, Berry Anthony Johannus**
  **Redhill, Surrey RH1 1DL (GB)**
• **Karadi, Ravichandra**
  **Redhill, Surrey RH1 1DL (GB)**

(74) Representative: **Hardingham, Christopher Mark**
  **NXP Semiconductors**
  **Intellectual Property and Licensing Department**
  **Betchworth House**
  **57-65 Station Road**
  **Redhill**
  **Surrey RH1 1DL (GB)**

(54) **Multi-level switching converter**

(57)    A switched-mode power converter (30) comprising a power supply configured to provide three or more distinct power supply voltage levels $(GND, V_0 \ldots {}_n)$ at respective power supply lines; first and second output connections (31, 32) for connecting across an output load impedance (33); a first plurality of switches $(s_G, s_0, s_1 \ldots s_{n-1}, s_n)$ switchably connecting each of the power supply lines to the first output connection (31); a second plurality of switches $(s'_G, s'_0, s'_1 \ldots s'_{n-1}, s'_n)$ switchably connecting each of the power supply lines to the second output connection (32); and a switching controller (34) configured to operate the first and second plurality of switches to cause a voltage between the first and second output connections to vary between a plurality of distinct output voltage levels in response to an input voltage signal $(V_{in})$, wherein the three or more distinct power supply voltage levels are unequally spaced relative to each other.

Fig. 3

EP 2 309 638 A1

**Description**

The invention relates to multi-level switched-mode power converters, in which multiple power supplies provide a converter with multiple supply voltage lines which are switched to obtain a multi-level differential voltage output in response to a time-varying input signal.

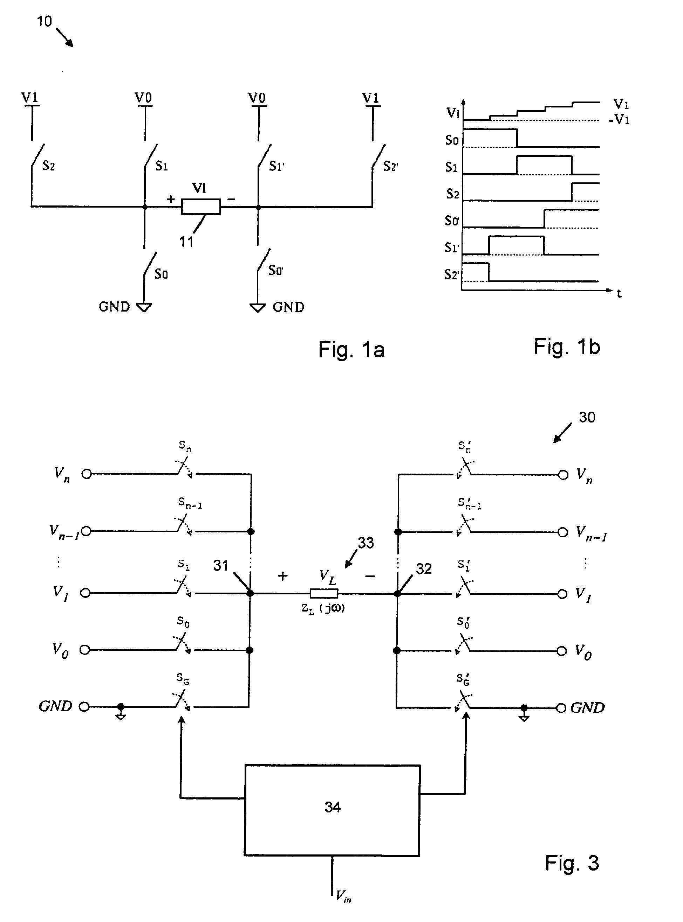

Multi-level switched-mode power converters are used in class-D amplifiers, inverters and in other applications. All power converters need a power supply to provide at least two voltage lines (GND and $V_0$). With $n$ ($n \geq 0$) additional power supplies whose output voltages are equally spaced relative to each other (including the voltages $V_0$ and GND), using conventional power converter designs a ($2n + 3$)-level power stage can be implemented. For example, a 5-level power stage can be implemented with supply voltage levels of $Vs$, $Vs/2$ and GND at respective power supply lines, which provides five distinct output levels of $-Vs$, $-Vs/2$, 0, $Vs/2$, and $Vs$. An exemplary 5-level switched-mode power converter 10 having a full-bridge topology using 1 additional supply (n =1) is shown in figure 1a, operable according to the switching configuration shown in figure 1b. This type of converter is described in more detail in WO 2006/106471. Five distinct differential output voltage levels across the load 11 can be provided, being $-V1$, $-V_0$, 0, $V_0$ and $V_1$. The output $V_1$ of the power stage may be directly connected to the load 11 or may be filtered to reduce the switching harmonics.

Additional output levels to reduce output harmonics can be added using additional power supplies, or by using additional supply voltage lines derived from existing lines, for example using DC-DC converters. Additional supply lines consequently require added hardware, and also increase the power consumption of the overall circuit. In many applications, such additional supply voltage lines cannot be justified on cost, power or space requirements.

It is an object of the invention to address the above-mentioned problem.

According to the invention there is provided a switched-mode power converter comprising:

a power supply configured to provide three or more distinct power supply voltage levels at respective power supply lines;
first and second output connections for connecting across an output load impedance;
a first plurality of switches switchably connecting each of the power supply lines to the first output connection;
a second plurality of switches switchably connecting each of the power supply lines to the second output connection; and
a switching controller configured to operate the first and second plurality of switches to cause a voltage between the first and second output connections to vary between a plurality of distinct output voltage levels,
wherein the three or more distinct power supply voltage levels are unequally spaced relative to each other.

The power supplies and control of the switched-mode converter are preferably chosen such that the maximum number of differential output voltage levels are obtained.

By unequally spacing the power supply voltage levels, and operating the plurality of switches accordingly, a greater number of distinct output voltage levels is possible, allowing for a reduction in high-frequency components of the output power from the converter. This results in a more efficient converter that requires less filtering.

The three or more distinct power supply voltage levels may be provided by a ground voltage line, a first supply voltage line and a second supply voltage line. The power supply may optionally comprise a voltage converter configured to derive the second voltage level from the first supply voltage line, or vice versa. Using a voltage converter removes the need for a separate power supply to be used.

The plurality of distinct output voltage levels are preferably, but not necessarily, equally spaced between a maximum and minimum output voltage, the spacing between the plurality of distinct voltage levels equalling a difference between two of the three or more distinct power supply voltage levels.

The number of distinct output voltage levels is preferably an odd number, because one of the voltage levels is provided by a ground (zero) voltage and the other voltage levels, at least in a differential implementation, are symmetric about zero.

The switching controller is preferably configured to close only one of each of the first and second plurality of switches at any time.

The power supply may be configured to provide distinct voltage levels at zero, a first voltage and a second voltage, the switching controller being configured such that the voltage between the first and second output connections varies between seven distinct voltage levels. In this case, the second voltage is preferably approximately either two thirds or one third of the first voltage. These two preferred cases allow for equally spaced output voltage levels when using only three distinct power supply voltage levels.

The power supply may optionally be configured to provide a further distinct power supply voltage level at a third voltage, the switching controller being configured such that the voltage between the first and second output connections varies between thirteen distinct voltage levels. In this case, the second voltage is preferably approximately two thirds of the first voltage and the third voltage is approximately one sixth of the first voltage. This preferred case allows for equally spaced output voltage levels when using only four distinct power supply voltage levels.

The number of distinct output voltage levels, N, is preferably related to the number of additional power supplies $n$ providing the three or more distinct voltage levels at respective power supply lines by the relationship

$$N = 1 + \frac{(n+2)!}{n!}$$

The switching controller is preferably configured to compare an input voltage signal with a plurality of waveforms at a switching frequency to generate a plurality of corresponding pulse-width-modulation signals for driving the first and second plurality of switches. The plurality of waveforms are preferably triangular waveforms.

According to a second aspect of the invention there is provided a method of operating the switched-mode power converter according to the first aspect of the invention, the method comprising:

receiving an input voltage signal;
comparing the input voltage signal with a plurality of waveforms; and
generating pulse-width-modulated switching signals for the first and second plurality of switches to cause the output voltage to vary between the plurality of distinct output voltage levels in response to the input voltage signal.

The invention is described in detail below by way of example and with reference to the accompanying drawings, in which:

figure 1 a is a schematic circuit diagram of a five-level power-stage converter;
figure 1b is a switching configuration for the power-stage converter of figure 1a;
figures 2a-c are spectra showing out-of-band spectral content above a normalised frequency for a 3-level, 7-level and a 13-level PWM converter respectively;
figure 3 is a schematic diagram of a multi-level switched-mode power converter according to the invention;
figure 4 is a diagram of a sampled input waveform as part of a PWM encoding process, using seven levels and triangle carriers;
figure 5 is a schematic circuit diagram of a 7-level power converter using a boost converter for a second voltage supply;
figure 6 is an exemplary output waveform from a 7-level power converter according to the invention;
figure 7 is a schematic circuit diagram of a 7-level power converter using MOS transistors for switches; and
figure 8 is a schematic circuit diagram of an alternative embodiment of a 7-level power converter, using a buck converter for the second voltage supply.

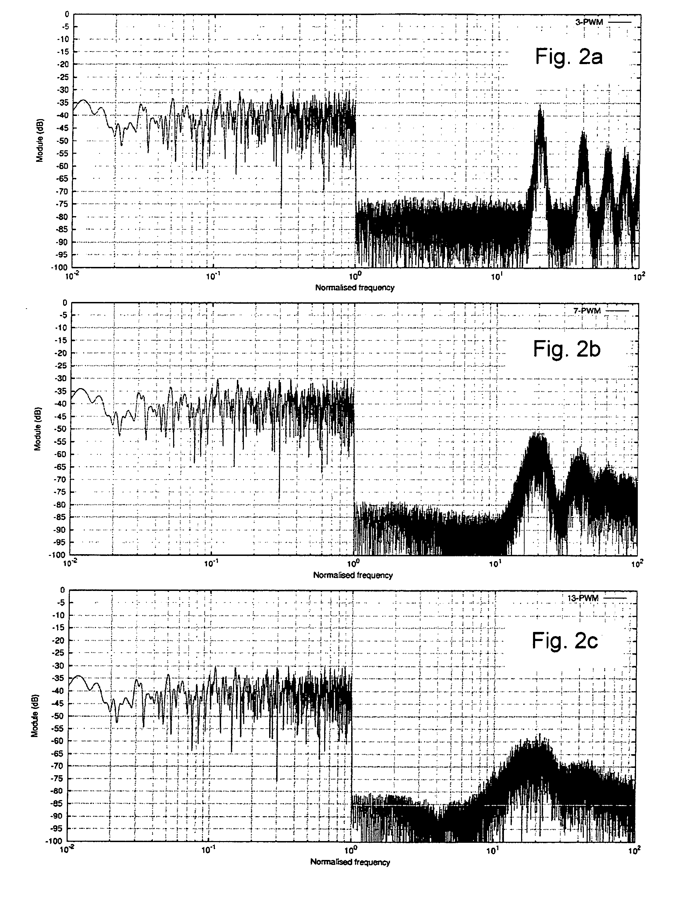

In conventional power converters having $n+2$ distinct power supply voltage lines, $(2n + 3)$ distinct output differential voltage levels can be obtained. With the present invention, however, using $n+2$ distinct supply voltage lines, but with unequally-spaced voltages, more than $(2n + 3)$ distinct differential output voltage levels can be obtained, as described in more detail below. This enables the advantages of multi-level operation such as a simplified output filter, or in some cases filter-free operation, and lower electromagnetic interference with less of the disadvantages associated with an increased number of power supply lines. These advantages are illustrated in the simulated spectra shown in figures 2a-c, which show the power spectrum of a discrete-amplitude signal with no filtering applied in three different multi-level converters. Figure 2a shows the power spectrum of a three-level converter (i.e. with no additional supplies), in which strong harmonics can be seen at high frequencies. Figure 2b shows the power spectrum of a seven-level converter according to the invention (using one additional supply), in which case these harmonics are much reduced. Figure 2c shows the power spectrum of a thirteen-level converter (i.e. with two additional supplies), in which case the harmonics are further reduced. In all cases the reference signal is the same, being a flat-spectrum signal (all frequencies being normalised to the reference signal bandwidth), with $V_{rms} = 0.39V$ ($V_1 = 1V$), and pulse-width modulation is used to drive the converter.

Figures 2a-c show that the power in the high-frequency portion of the spectrum, i.e. at frequencies above the normalisation frequency, reduces as the number of discrete (and equidistant) output levels increases. Using the high-frequency power of the conventional 3-level converter as a reference (representing 100%, or OdB), for the 7-level converter the high-frequency power is 12% of the reference (or -9dB), while in the 13-level converter the high frequency power is further reduced to 3% of the reference (or -15dB).

An exemplary power converter 30 is shown in the schematic circuit diagram of figure 3, which illustrates the general principle of the invention. A total of $n+1$ voltage supplies are provided, which provide $n+2$ distinct voltage lines (including GND). An output load impedance 33 is connected between a first output connection 31 and a second output connection 32. A first plurality of switches $S_G$, $S_0$, $S_1$ ... $S_{n-1}$, $S_n$ switchably connect the first output connection 31 with the respective power supply voltage lines GND, $V_0$, $V_1$ ... $V_{n-1}$, $V_n$. A second plurality of switches $s'_G$, $s'_0$, $s'_1$ ... $s'_{n-1}$, $s'_n$ switchably connect the first output connection 32 with the respective power supply voltage levels GND, $V_0$, $V_1$ ... $V_{n-1}$, $V_n$.

A switching controller 34 is provided for controlling the operation of each of the first and second plurality of switches, the switching controller receiving an input voltage signal $V_{in}$ and deriving an appropriate combination of switching signals from a reading of the input voltage signal level. The switching controller 34 preferably operates according to a modified pulse-width modulation scheme, described in more detail below.

If all line voltages ($V_i$, $i \in [0,n]$ and GND) are different, and a voltage difference value between any two of these lines is available using only one combination, a maximum number of differential output levels can be achieved using this multi-level full-bridge topology. This maximum number of differential output levels N is given by:

$$N = 1 + \frac{(n+2)!}{n!} \qquad \text{(equation 1)}$$

This results in 7 distinct output levels for 3 input lines (n = 1), 13 output levels for 4 input lines (n = 2), 21 output levels for 5 input lines (n = 3) and so on.

The number of differential output levels will be lower if some of the supply voltage levels are the same and/or the difference between any combination of two of the supply voltage levels is not unique.

Although there exist infinitely many different combinations of supply voltage levels that yield the above maximum number of different output levels (using n additional voltages to GND and $V_0$), the more useful cases are those which yield differential output levels which are at least approximately equidistant, as these can be used to provide a more uniform range of output voltage signals. Nevertheless, the ratio between voltages is not always unique, as shown below in Table 1, as there are two possible values for $V_0$ in a 7 level implementation.

Table 1: Normalised voltage supplies for equidistant output voltage levels.

|        | 3 levels | 7 levels   | 13 levels |
|--------|----------|------------|-----------|
| $V_0$  | 1        | 1/3 or 2/3 | 1/6       |
| $V_1$  |          | 1          | 2/3       |
| $V_2$  |          |            | 1         |

This multi-level approach can be analysed from another standpoint. Instead of designing specific supplies to achieve equidistant output levels, the boundary conditions may set the supply voltages, and the multi-level converter might use them all to encode more efficiently. For example, let us consider an audio amplifier for automotive applications. A typical car battery, supplying about 12V or 14V, is not necessarily high enough to adequately power a set of loudspeakers. A boost converter may be used to provide a suitable higher voltage, supplying for example 35V. In such a system, two voltage supplies are therefore available, providing three power supply lines. A multi-level power converter according to the invention can use both to generate a multi-level signal in such a case, even though the output levels will not be equidistant. The seven available differential voltages derived from voltage lines at 0V, 12V and 35V are -35V, -23V, - 12V, 0V, 12V, 23V and 35V. Appropriate changes to the switching controller can be made so that the switches connected to the different voltage lines are timed to operate according to an input signal.

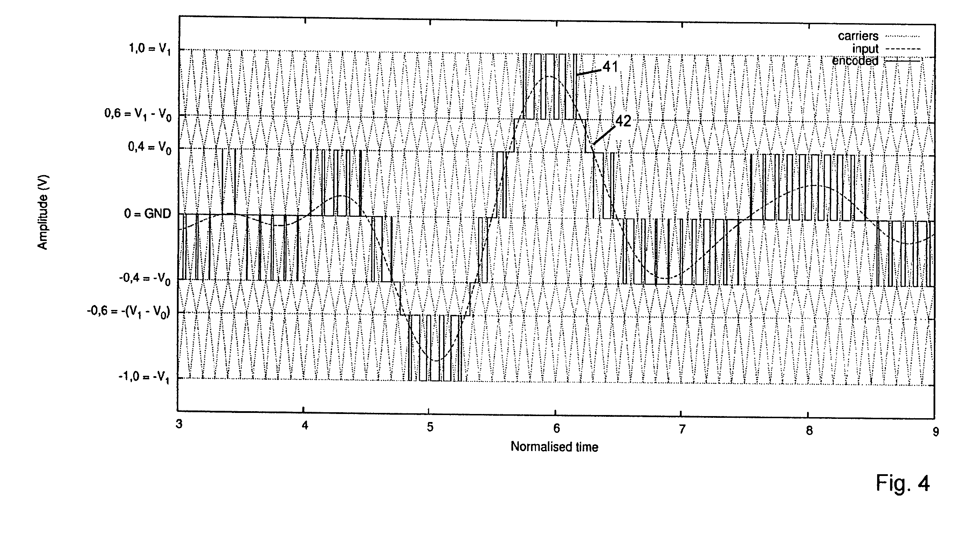

Regardless of whether the output voltage levels are to be equally spaced, the multi-level converter requires a switching modulation scheme to generate the proper control signals to drive the switches. Figure 4 illustrates an exemplary waveform 41 generated from an input signal 42 using such a modulation scheme, the amplitude of each signal being normalised. The seven distinct output voltage levels are provided according to the control scheme described below and detailed in table 2, with $V_1$ = 1 and $V_0$ = 0.4. The way in which the modulation scheme is generated can be considered to be an extension of a PWM (pulse-width modulation) scheme, being the most common type of modulation used in conventional switched-mode power converters. In order to generate a multi-level PWM signal (with *m* different levels), a carrier must be used between each two consecutive levels (i.e. it is necessary to use *m* - 1 carriers), each carrier signal being in the form of a triangular waveform. Within each carrier the encoded signal is generated as a regular PWM signal. The overall effect is to generate PWM switching waveforms that alternate between adjacent available voltage levels. Figure 4 further illustrates how the PWM switching signal 41 corresponds with the input signal 42.

In order to keep the properties of a PWM scheme, and so encode at a constant frequency, adjacent carrier waveforms are phase shifted 180° relative to each other (assuming triangular waveforms), otherwise the reference signal could evade the carriers and skip some pulses.

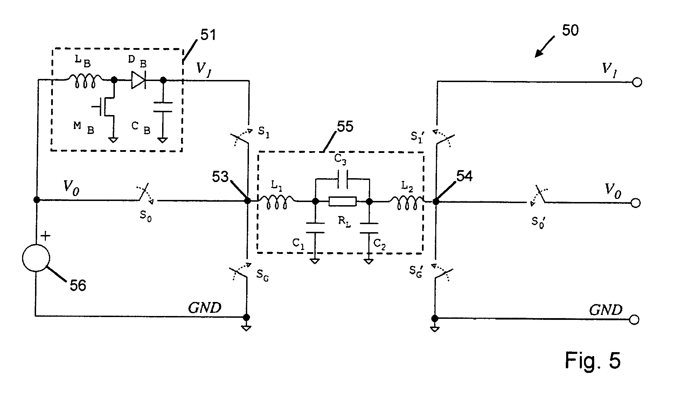

The schematic circuit diagram in figure 5 shows an embodiment of a 7-level power converter 50. A single voltage source 56 provides a voltage level $V_0$. A boosted supply at $V_1$ is generated from $V_0$ by means of a boost converter 51. The voltage $V_1$ could alternatively be generated using a capacitive up-converter or by using a separate voltage source. In the switch arrangement shown, three switches $S_G$, $S_0$ and $S_1$ connect the three power supply voltage lines GND, $V_0$ and $V_1$ to a first output connection 53, and three switches $s'_G$, $s'_0$ and $s'_1$ connect the three power supply lines to a second output connection 54. An output load 55, having a combined resistive, capacitive and inductive impedance, is connected between the first and second output connections 53, 54. Seven different output voltage levels can be applied across the output load 55, being: $-V_1$, $-V_0$, $-(V_1 - V_0)$, GND, $(V_1 - V_0)$, $V_0$ and $V_1$. Table 2 below shows the choice of which switches are to be turned ON to correspond to each of these output voltage levels. The levels are in ordered according to the resulting output voltage level $V_L$, i.e. from lowest (level 1) to highest (level 7). Levels 2 and 3, and levels 5 and 6, would be reversed depending on the chosen value for $V_0$ (see table 1 above).

Table 2: Control of an exemplary 7-level switched-mode power converter.

| Level | ON Switches | $V_o+$ | $V_{o-}$ | $V_L$ |
|---|---|---|---|---|
| 1 | $S_G$ $S'_1$ | GND | $V_1$ | $-V_1$ |
| 2 | $S_G$ $S'_0$ | GND | $V_0$ | $-V_0$ |
| 3 | $S_0$ $S'_1$ | $V_0$ | $V_1$ | $-(V_1-V_0)$ |
| 4 | $S_G$ $S'_G$ | GND | GND | 0 |
| 5 | $S_1$ $S'_0$ | $V_1$ | $V_0$ | $V_1-V_0$ |
| 6 | $S_0$ $S'_G$ | $V_0$ | GND | $V_0$ |
| 7 | $S_1$ $S'_G$ | $V_1$ | GND | $V_1$ |

For output level 4, where the output voltage $V_L$ is 0, it will be evident that other combinations of switches can also be used to generate the same output, these being $S_0$ $S'_0$ and $S_1$ $S'_1$.

If $V_1 = 2V_0$, i.e. if the supply voltage levels are equidistant, then only five effective levels can be generated, since $V_1-V_0 = V_0$. To obtain seven distinct output voltage levels therefore, the supply voltage levels need to be unequally spaced relative to each other.

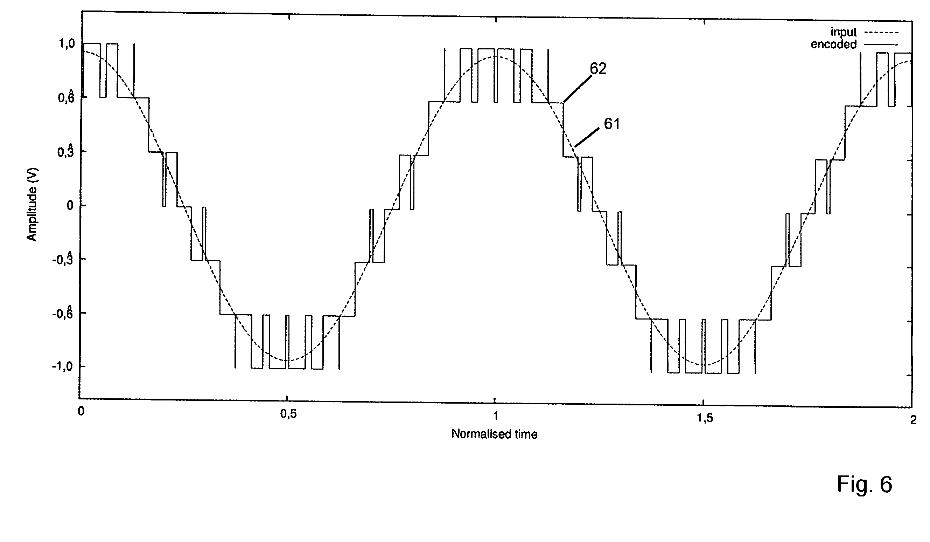

Figure 6 illustrates a sinusoidal voltage 61 input waveform and a resulting switched output signal 62 generated by a modulation scheme using three supply voltage lines. The output signal 62 varies over seven distinct and equally-spaced voltage levels, which can be achieved by the power supply voltages levels $V_1$ and $V_0$ being related such that $V_0$ equals either $V_1/3$ or $2V_1/3$, as in table 1 above.

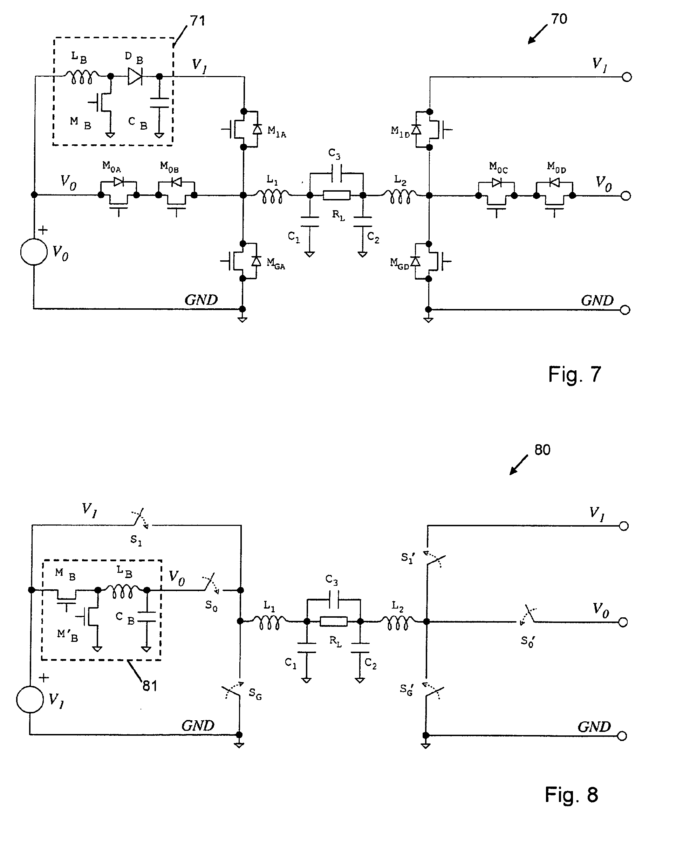

A transistor implementation of the converter 50 shown in figure 5, using MOS transistors, is shown in the converter 70 in figure 7. For switches $s_0$ and $s'_0$, back-to-back transistors are used to avoid body-diode conduction.

An alternative embodiment using a buck converter to generate the additional supply in a 7-level implementation is shown in the converter 80 of figure 8. The buck converter 81 produces a voltage of $V_0$ from the supply voltage of $V_1$. Again, 7 levels can be generated as in the previous embodiments described above.

The switching scheme in table 2 above can be used to generate the required output levels for the seven output level converter 80 of figure 8. If the output of the buck converter $V_0 = V_1/3$, then uniformly spaced levels of $-V_1$, $-2V_1/3$, $-V_1/3$, 0, $V_1$, $2V_1/3$ and $V_1/3$ can be generated.

Power converters according to aspects of the invention may for example be used in Class D amplifiers or DC/AC inverters.

Other embodiments are within the scope of the invention, as defined by the appended claims.

**References**

[1] WO 2006/106471

[2] M. Berkhout, Integrated Audio Amplifiers in BCD Technology, Boston / Dordrecht / London: Kluwer Academic Publishers, 1997

**Claims**

1.   A switched-mode power converter (30,50,70,80) comprising
a power supply configured to provide three or more distinct power supply voltage levels (GND, $V_0$... $_n$) at respective

power supply lines;

first and second output connections (31, 32) for connecting across an output load impedance (33);

a first plurality of switches ($s_G, s_0, s_1 ... s_{n-1}, s_n$) switchably connecting each of the power supply lines to the first output connection (31);

a second plurality of switches ($s'_G, s'_0, s'_1 ... s'_{n-1}, s'_n$) switchably connecting each of the power supply lines to the second output connection (32); and

a switching controller (34) configured to operate the first and second plurality of switches to cause a voltage between the first and second output connections to vary between a plurality of distinct output voltage levels in response to an input voltage signal ($V_{in}$),

wherein the three or more distinct power supply voltage levels are unequally spaced relative to each other.

2. The power converter (50,70,80) of claim 1 wherein the spacing between adjacent distinct output voltage levels equals a difference between two of the three or more distinct power supply voltage levels.

3. The power converter (50,70,80) of claim 1 or claim 2 wherein the three or more distinct power supply voltage levels are provided by a ground voltage line (GND), a first voltage supply line ($V_0$) and a second voltage supply line ($V_1$).

4. The power converter (50,70,80) of claim 3 wherein the power supply comprises a voltage converter (51,71,81) configured to derive the second voltage level from the first supply voltage line.

5. The power converter (30,50,70,80) of any preceding claim wherein the plurality of distinct output voltage levels are equally spaced between a maximum and minimum output voltage.

6. The power converter (30,50,70,80) of any preceding claim wherein the number of distinct output voltage levels is an odd number.

7. The power converter (30,50,70,80) of any preceding claim wherein the switching controller (34) is configured to close only one of each of the first and second plurality of switches at any time.

8. The power converter (50,70,80) of claim 1 wherein the power supply is configured to provide distinct voltage levels at zero (GND), a first voltage ($V_1$) and a second voltage ($V_0$), the switching controller being configured such that the voltage between the first and second output connections varies between seven distinct voltage levels.

9. The power converter (50,70,80) of claim 8 wherein the second voltage ($V_0$) is approximately either two thirds or one third of the first voltage ($V_1$).

10. The power converter of claim 8 wherein the power supply is configured to provide a further distinct power supply voltage level at a third voltage, the switching controller being configured such that the voltage between the first and second output connections varies between thirteen distinct voltage levels.

11. The power converter of claim 10 wherein the second voltage is approximately two thirds of the first voltage and the third voltage is approximately one sixth of the first voltage.

12. The power converter of any preceding claim wherein the number of distinct output voltage levels, N, is related to the number of power supplies $n+1$ providing the three or more distinct power supply voltage levels at respective power supply lines (GND,$V_{0...n}$) by the relationship

$$N = 1 + \frac{(n+2)!}{n!}$$

13. The power converter of any preceding claim wherein the switching controller is configured to compare an input voltage signal ($V_{in}$) with a plurality of waveforms at a switching frequency to generate a plurality of corresponding pulse-width-modulation signals for driving the first and second plurality of switches.

14. The power converter of claim 13 wherein the plurality of waveforms are triangular waveforms.

**15.** A method of operating the switched-mode power converter according to claim 1, the method comprising:

receiving an input voltage signal ($V_{in}$);
comparing the input voltage signal with a plurality of waveforms; and
generating pulse-width-modulated switching signals for the first and second plurality of switches to cause the output voltage to vary between the plurality of distinct output voltage levels in response to the input voltage signal ($V_{in}$).

Fig. 1a                    Fig. 1b

Fig. 3

Fig. 2a

Fig. 2b

Fig. 2c

Fig. 4

EP 2 309 638 A1

Fig. 5

Fig. 6

EP 2 309 638 A1

Fig. 7

Fig. 8

Europäisches
Patentamt

European
Patent Office

Office européen
des brevets

**EUROPEAN SEARCH REPORT**

Application Number

EP 09 25 2395

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | RODRIGUEZ J ET AL: "Multilevel Voltage-Source-Converter Topologies for Industrial Medium-Voltage Drives" IEEE TRANSACTIONS ON INDUSTRIAL ELECTRONICS, IEEE SERVICE CENTER, PISCATAWAY, NJ, USA, vol. 54, no. 6, 1 December 2007 (2007-12-01), pages 2930-2945, XP011194602 ISSN: 0278-0046 * page 2937 - page 2938; figures 15-17 * | 1-3,5-6, 8-10, 12-15 | INV. H02M7/483 H03F3/217 H02M1/12 |
| X | SEKHAR K C ET AL: "An Eight-level Inverter System for an Induction Motor with Open-end Windings" POWER ELECTRONICS AND DRIVES SYSTEMS, 2005. PEDS 2005. INTERNATIONAL C ONFERENCE ON KUALA LUMPUR, MALAYSIA 28-01 NOV. 2005, PISCATAWAY, NJ, USA,IEEE, vol. 1, 28 November 2005 (2005-11-28), pages 219-223, XP010909730 ISBN: 978-0-7803-9296-0 * the whole document * | 1-3,5-6, 13-15 | |
| X | KOU X ET AL: "Over-distention operation of cascaded multilevel inverters" ELECTRIC MACHINES AND DRIVES CONFERENCE, 2003. IEMDC'03. IEEE INTERNAT IONAL JUNE 1-4, 2003, PISCATAWAY, NJ, USA,IEEE, vol. 3, 1 June 2003 (2003-06-01), pages 1535-1542, XP010644375 ISBN: 978-0-7803-7817-9 * the whole document * | 1-3,5-6, 12-15 | TECHNICAL FIELDS SEARCHED (IPC) H02M H03F H02P H02J |
| X | US 2005/007797 A1 (ZOCCHI ANDREA [IT] ET AL) 13 January 2005 (2005-01-13) * paragraphs [0071] - [0086]; figures 4,5 * | 1-4,6, 13,15 | |

-/--

The present search report has been drawn up for all claims

| Place of search | Date of completion of the search | Examiner |
|---|---|---|
| Munich | 3 March 2010 | Braccini, Roberto |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

Europäisches
Patentamt

European
Patent Office

Office européen
des brevets

**EUROPEAN SEARCH REPORT**

Application Number

EP 09 25 2395

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/034246 A1 (NAKATA JOSUKE [JP]) 15 February 2007 (2007-02-15) * paragraph [0005]; figures 24-27 * ----- | 1-3,6, 13-15 | |
| A,D | WO 2006/106471 A1 (KONINKL PHILIPS ELECTRONICS NV [NL]; DE CREMOUX GUILLAUME [GB]) 12 October 2006 (2006-10-12) * page 5, line 22 - page 9, line 5; figures 1-4 * ----- | 1-15 | |

TECHNICAL FIELDS
SEARCHED (IPC)

The present search report has been drawn up for all claims

| Place of search | Date of completion of the search | Examiner |
|---|---|---|
| Munich | 3 March 2010 | Braccini, Roberto |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.................................................................................................

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**                    EP 09 25 2395

This annex lists the patent family members relating to the patent documents cited in the above-mentioned European search report.
The members are as contained in the European Patent Office EDP file on
The European Patent Office is in no way liable for these particulars which are merely given for the purpose of information.

03-03-2010

| Patent document<br>cited in search report | | Publication<br>date | Patent family<br>member(s) | | Publication<br>date |
|---|---|---|---|---|---|
| US 2005007797 | A1 | 13-01-2005 | AU | 2002354596 A1 | 29-01-2003 |
| | | | BR | 0205733 A | 06-01-2004 |
| | | | CN | 1526193 A | 01-09-2004 |
| | | | EP | 1407534 A2 | 14-04-2004 |
| | | | WO | 03007464 A2 | 23-01-2003 |
| | | | IT | VA20010022 A1 | 13-01-2003 |
| | | | ZA | 200301352 A | 30-03-2004 |
| US 2007034246 | A1 | 15-02-2007 | AT | 406607 T | 15-09-2008 |
| | | | AT | 425574 T | 15-03-2009 |
| | | | AU | 2003242109 A1 | 04-01-2005 |
| | | | CA | 2523574 A1 | 16-12-2004 |
| | | | CN | 1771641 A | 10-05-2006 |
| | | | EP | 1633030 A1 | 08-03-2006 |
| | | | EP | 1901419 A2 | 19-03-2008 |
| | | | ES | 2307944 T3 | 01-12-2008 |
| | | | ES | 2320045 T3 | 18-05-2009 |
| | | | HK | 1113236 A1 | 26-06-2009 |
| | | | WO | 2004109890 A1 | 16-12-2004 |
| | | | TW | 230492 B | 01-04-2005 |
| WO 2006106471 | A1 | 12-10-2006 | CN | 101160716 A | 09-04-2008 |
| | | | JP | 2008535433 T | 28-08-2008 |
| | | | US | 2008284511 A1 | 20-11-2008 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2006106471 A

**Non-patent literature cited in the description**

- **M. Berkhout.** Integrated Audio Amplifiers in BCD Technology. Kluwer Academic Publishers, 1997